**Europäisches Patentamt**

**European Patent Office**

**Office européen des brevets**

(11) Veröffentlichungsnummer: **0 625 835 A1**

# EUROPÄISCHE PATENTANMELDUNG

(21) Anmeldenummer: **94201420.0**

(22) Anmeldetag: **19.05.94**

(51) Int. Cl.5: **H04B 10/14**

(30) Priorität: **19.05.93 DE 4316811**

(43) Veröffentlichungstag der Anmeldung:
**23.11.94 Patentblatt 94/47**

(84) Benannte Vertragsstaaten:
**DE FR GB IT SE**

(71) Anmelder: **Philips Patentverwaltung GmbH**
**Wendenstrasse 35c**
**D-20097 Hamburg (DE)**

(84) **DE**

(71) Anmelder: **PHILIPS ELECTRONICS N.V.**
**Groenewoudseweg 1**
**NL-5621 BA Eindhoven (NL)**

(84) **FR GB IT SE**

(72) Erfinder: **Link, Thomas, Dipl.-Ing., c/o Philips**
**Patentverwaltung GmbH,**
**Wendenstrasse 35c**
**D-20097 Hamburg (DE)**
Erfinder: **Will, Dieter, Dipl.-Ing., c/o Philips**
**Patentverwaltung GmbH,**
**Wendenstrasse 35c**
**D-20097 Hamburg (DE)**
Erfinder: **Karl, Hubert, Prof. Dr., c/o Philips**
**Patentverwaltung GmbH,**
**Wendenstrasse 35c**
**D-20097 Hamburg (DE)**

(74) Vertreter: **Walz, Erich et al**
**Philips Patentverwaltung GmbH**
**Wendenstrasse 35 c**
**D-20097 Hamburg (DE)**

(54) **Optisches Übertragungssystem mit einer Laserdiode.**

(57) Die Erfindung bezieht sich auf ein optisches Übertragungssystem mit einer Laserdiode (2) und einer mit ihr gekoppelten Photodiode (3), deren Photostrom ($I_{Photo}$) einer Regelschaltung (32) zur Regelung der Lichtleistung ($P_{opt}$) zugeführt wird. Die Regelschaltung gibt eine erste und zweite Stellgröße ($U_{mod}$, $U_0$) für einen Modulationsstrom ($I_{mod}$) und einen Vorstrom ($I_0$) vor. Die Regelschaltung (32) enthält eine Anordnung zur Bestimmung eines aus der Lichtleistung ($P_{opt}$) und aus dem durch die Laserdiode fließenden Laserstrom ($I_{Laser}$) gebildeten Differentialquotienten ($k_0$).

Es wird vorgeschlagen, die Regelschaltung (32) einerseits vorzusehen zur Erzeugung der ersten Stellgröße ($U_{mod}$) mittels einer aus dem Mittelwert des Photostromes ($I_{Photo}$) abgeleiteten Regelgröße ($U_m$). Andererseits ist die Regelschaltung (32) vorgesehen zur Erzeugung der zweiten Stellgröße ($U_0$) aus dem gemessenen Differentialquotienten ($k_0$), aus dem Mittelwert ($P_m$) der optischen Leistung ($P_{opt}$) und aus dem Mittelwert ($I_m$) des Laserdiodenstroms ($I_{Laser}$).

FIG.3

Die Erfindung bezieht sich auf ein optisches Übertragungssystem mit einer Laserdiode und einer mit ihr gekoppelten Photodiode, deren Photostrom einer Regelschaltung zur Regelung der Lichtleistung zugeführt wird, die eine erste und zweite Stellgröße für einen Modulationsstrom und einen Vorstrom vorgibt und mit einer Anordnung zur Bestimmung eines aus der Lichtleistung und aus dem durch die Laserdiode fließenden Laserstrom gebildeten Differentialquotienten. Die Erfindung betrifft insbesondere einen optischen Sender für ein solches Übertragungssystem.

Derartige optische Sender werden beispielsweise in leitungsgebundenen, digitalen Übertragungssystemen, bei denen die Übertragung von Informationen über Lichtwellenleiter stattfindet, eingesetzt.

Aus der deutschen Offenlegungsschrift DE 38 17 836 A1 ist ein optischer Sender mit einer Laserdiode bekannt, der eine Regelschaltung zur Regelung der Lichtleistung der Laserdiode enthält. Eine Regelung der Lichtleistung ist erforderlich, da sich auf Grund von Alterungsprozessen die Kennlinie der Laserdiode ändert. Mit höherem Alter der Laserdiode verschiebt sich der Knickpunkt der Kennlinie der Laserdiode zu höheren Laserdiodenströmen hin und die Steilheit der Laserdiodenkennlinie verringert sich insbesondere für Laserdiodenströme im Bereich oberhalb des Knickpunktes. Der Laserdiodenstrom im Knickpunkt der Laserdiodenkennlinie wird als Schwellenstrom bezeichnet. Im oben genannten Stand der Technik ist eine als Monitordiode arbeitende Photodiode vorgesehen, die ein impulsförmiges Laserdiodensignal, dem ein impulsförmiges Pilotsignal überlagert ist, in einen Photostrom umsetzt. Dieser Photostrom wird der Regelschaltung zugeführt, die zwei analoge Regelzweige enthält zur Konstanthaltung der mittleren Lichtleistung und der Ruhelichtleistung und zur Regelung eines nur aus einem Gleichanteil bestehenden Vorstromes auf Werte größer als der Schwellenstrom der Laserdiode. Die Laserdiode erzeugt die Ruhelichtleistung, wenn sie nur mit dem Vorstrom angesteuert wird. Der Schwellenstrom darf nicht größer als der Vorstrom sein, damit der Aussteuerungsbereich der Laserdiode oberhalb des Knickpunktes ihrer Kennlinie liegt und Verzerrungen des Lichtsignals der Laserdiode vermieden werden. Der Regelschaltung liegt ein linearisiertes Kennlinienmodell der Laserdiode zu Grunde. Das Altern der Laserdiode kann allerdings mit einem überproportionalem Abflachen der Laserdiodenkennlinie verbunden sein.

Der Erfindung liegt die Aufgabe zu Grunde, ein Übertragungssystem der eingangs genannten Art anzugeben, dessen Funktion auch bei alterungsbedingtem überproportionalen Abflachen der Laserdiodenkennlinie sichergestellt ist und dessen Ruhelichtleistung und dessen maximale Lichtleistung konstant geregelt werden.

Diese Aufgabe wird dadurch gelöst, daß die Regelschaltung vorgesehen ist
- zur Erzeugung der ersten Stellgröße mittels einer aus dem Mittelwert des Photostromes abgeleiteten Regelgröße und
- zur Erzeugung der zweiten Stellgröße aus dem gemessenen Differentialquotienten, aus dem Mittelwert der optischen Leistung und aus dem Mittelwert des Laserdiodenstroms.

Ein alterungs- oder temperaturbedingtes überproportionales Abflachen der Laserdiodenkennlinie bedeutet besonders im Bereich der maximalen Lichtleistung der Laserdiode eine überproportionale Verkleinerung des Differentialquotienten der Kennlinie. Um dennoch sowohl die minimale als auch die maximale Lichtleistung der Laserdiode konstant zu halten, was einer Konstanthaltung der mittleren Lichtleistung und des Extinktionsfaktors entspricht, ist eine Regelschaltung erforderlich. Der Extinktionsfaktor ist das Verhältnis der Ruhelichtleistung zur maximalen Lichtleistung. Weiterhin muß die Regelschaltung gewährleisten, daß der Vorstrom der Laserdiode, der die hohe Lichtleistung der Laserdiode bestimmt, nicht unter den Schwellenstrom der Laserdiodenkennlinie sinkt, denn dies würde zu Verzerrungen im Ausgangssignal der Laserdiode führen. Der in der Regelschaltung angeordnete Regler sorgt durch den Vergleich einer aus dem Mittelwert des Photostromes abgeleiteten Regelgröße mit einem vorgegebenen Sollwert dafür, daß die mittlere Lichtleistung der Laserdiode konstant gehalten wird. Dazu regelt der Regler die erste Stellgröße bzw. den Modulationsstrom nach, mit dem der Information tragende immpulsförmige Anteil des Lichtsignals erzeugt wird. Weiterhin wird in der Regelschaltung der Vorstrom bestimmt. Dazu wird ein linearisiertes Kennlinienmodell der Laserdiode angesetzt. Aus den gemessenen Differentialquotienten im Bereich der maximalen Lichtleistung der Laserdiode und dem Arbeitspunkt der Laserdiode ergibt sich damit der zu bestimmende Vorstrom. Der Arbeitspunkt der Laserdiode liegt beim Mittelwert des Laserdiodenstromes und beim vorgegebenen Mittelwert der Lichtleistung der Laserdiode. Vorteilhaft hält eine solche Regelschaltung durch Zusammenwirken des Reglers und des den Vorstrom bestimmenden Teils der Regelschaltung sowohl die mittlere Lichtleistung als auch den Extinktionsfaktor konstant. Beim Abflachen der Laserdiodenkennlinie wird außerdem der Vorstrom erhöht, so daß trotz einer Verschiebung des Schwellenstromes zu höheren Laserdiodenströmen bei Alterung der Laserdiode der Vorstrom immer größer als der Schwellenstrom der Laserdiode bleibt.

Eine Weiterbildung der Erfindung ist dadurch gekennzeichnet, daß die Regelschaltung vorgesehen ist zur Schätzung des Mittelwerts des Laserdiodenstroms durch die Summe aus dem Mittelwert des Modulationsstromes und eines vorher bestimmten und gespeicherten Vorstromwertes .

Der Mittelwert des Laserdiodenstromes, der dem Laserdiodenstrom im Arbeitspunkt der Laserdiodenkennlinie entspricht, kann nicht direkt aus dem von der als Monitordiode arbeitenden Photodiode erzeugten Photostrom abgeleitet werden. Aus diesem Grund ist eine Schätzung des Mittelwertes des Laserdiodenstromes aus anderen in der Regelschaltung vorliegenden Größen erforderlich. Aus der Kennlinie der Laserdiode ergibt sich, daß der Mittelwert des Laserdiodenstromes die Summe aus dem Mittelwert des Modulationsstromes und des Vorstromes ist. Geht man von einem gegenüber der Zeitdauer eines Impulses bzw. einer Impulspause des durch den Modulationsstrom bestimmten von der Laserdiode erzeugten Datensignales sehr großen Beobachtungszeitraum aus, dann ist die Anzahl der Impulse näherungsweise gleich der Anzahl an Impulspausen, wenn wie im vorliegenden Fall von statistischer Gleichverteilung auszugehen ist. Vorteilhaft ergibt sich somit eine sehr einfache Berechnung des Mittelwertes des Modulationsstromes durch den halben Amplitudenwert des Modulationsstromes. Der weiterhin zur Berechung des Mittelwertes der Laserdiodenstromes erforderliche Vorstromwert kann zum jeweiligen Bestimmungszeitpunkt nicht aus einer aktuellen Zustandsgröße der Regelschaltung abgeleitet werden, da der Vorstrom gerade erst aus dem Mittelwert des Laserdiodenstromes bestimmt werden muß. Aus diesem Grunde ist es vorteilhaft, einen Speicher vorzusehen, in dem ein bereits bestimmter Vorstromwert gespeichert wird. In einem der nachfolgenden Bestimmungszeitpunkte wird ein so gespeicherter Vorstromwert zur Bestimmung des Mittelwertes des Laserdiodenstromes verwendet. Danach wird der Speicher mit dem neu berechneten Vorstromwert aktualisiert.

In einer weiteren Ausgestaltung der Erfindung ist die Regelschaltung vorgesehen zur Verwendung der am Ausgang eines Reglers anliegenden ersten Stellgröße zur Bestimmung des Vorstroms.

Zur Bestimmung des Mittelwertes des Laserdiodenstromes, der zur Bestimmung des Vorstromes benötigt wird, muß der Wert des aktuellen Modulationsstromes bzw. der halbe Wert des aktuellen Modulationsstromes verfügbar sein. Die am Ausgang des Reglers anliegende Stellgröße ist direkt proportional zum Modulationsstrom. Auf einfache Weise läßt sich aus dieser Stellgröße somit der aktuelle Wert des Modulationsstromes bestimmen.

Vorteilhaft wird die Erfindung weiterhin dadurch ausgestaltet, daß Modulationsmittel vorgesehen sind zur Modulation des Laserstroms mit einem Pilotstrom und daß die Regelschaltung zur Bestimmung des Differentialquotienten durch Ermittlung einer Meßgröße vorgesehen ist, die der Amplitude derjenigen Komponente des Photostroms entspricht, deren Frequenz gleich der Grundfrequenz des Pilotstromes ist.

Zur Bestimmung des Vorstromes ist die Verfügbarkeit des Wertes des Differentialquotienten bzw. der Steilheit der Laserdiodenkennlinie im Bereich der maximalen Lichtleistung erforderlich. Aus diesem Grund wird dem hochfrequenten Datensignal der Laserdiode ein niederfrequentes Pilotsignal überlagert, dessen Amplitude sehr viel kleiner als die Amplitude des Datensignales ist. Die Grundfrequenz des Pilotsignals liegt im Durchlaßbereich der Photodiode, die Tiefpaßwirkung besitzt. Die der Grundfrequenz des Pilotsignals entsprechende Frequenzkomponente des Photostromes wird mit Filtermitteln selektiert. Sie ist ein Maß für den Differentialquotienten bzw. die Steilheit der Laserdiodenkennlinie im Bereich der maximalen Lichtleistung der Laserdiode.

Eine andere Ausgestaltung der Erfindung ist dadurch gekennzeichnet, daß zur Einstellung der Amplitude des Pilotstromes die erste Stellgröße vorgesehen ist.

Um eine Verfälschung des Datensignals der Laserdiode durch das überlagerte Pilotsignal und einen damit verbundenen Datenverlust zu vermeiden, ist es erforderlich, daß die Amplitude des Pilotsignals wesentlich kleiner als die Amplitude des Datensignals ist. Der das Pilotsignal erzeugende Pilotstrom muß daher sehr viel kleiner als der das Datensignal erzeugende Modulationsstrom sein. Dies wird erreicht, indem die Amplituden des Pilotstromes und des Modulationsstromes in einem festen Verhältnis zueinander stehen. Bei der vorliegenden Erfindung werden beide Ströme aus der am Ausgang des Reglers anliegenden ersten Stellgröße abgeleitet. Der Wandlungsfaktor eines Wandlers, der aus der ersten Stellgröße den Modulationsstrom erzeugt, ist um einen geeigneten Faktor größer als der Wandlungsfaktor eines anderen Wandlers, der aus der ersten Stellgröße den Pilotstrom erzeugt. Die entsprechenden Faktoren sind schaltungstechnisch sehr leicht zu realisieren.

Eine andere Ausgestaltung der Erfindung ist dadurch gekennzeichnet, daß ein Schaltungsblock vorgesehen ist, der zur Erzeugung der zweiten Stellgröße dient, daß an den Eingängen dieses Schaltungsblockes die Regelgröße, die Meßgröße und die erste Stellgröße anliegt und daß der Schaltungsblock einen Speicher zur Speicherung mindestens eines Wertes des Vorstromes enthält.

Die oben beschriebene Bestimmung des Vorstromes ist durch einen einzigen Schaltungsblock zu realisieren. Dieser liefert nach Auswertung der angegebenen drei Eingangsgrößen und des gespeicherten Vorstromwertes eine zweite Stellgröße. Diese zweite Stellgröße ist proportional zum zu bestimmenden Vorstrom. Vorteilhaft wird somit der oben erläuterte Weg zur Bestimmung des Vorstromes schaltungstechnisch umgesetzt.

Das zur Bestimmung der Meßgröße aus dem Photostrom eine Bandpaßfilterung, eine Demodulation und eine anschließende Tiefpaßfilterung vorgesehen sind, ist eine andere Möglichkeit die Erfindung vorteilhaft auszugestalten.

Um die Meßgröße, die ein Maß für den Differentialquotienten der Laserdiodenkennlinie im Bereich der maximalen Lichtleistung darstellt, aus dem Photostrom abzuleiten, ist es erforderlich, den der Grundfrequenz des Pilotsignals entsprechenden Frequenzanteil des Photostromes zu selektieren und ins Basisband zu transformieren. Die Selektion dieses Frequenzanteils des Photostromes wird vorteilhaft durch eine Bandpaßfilterung durchgeführt. Die Transformation ins Basisband zur Erzeugung einer nur aus einem Gleichanteil bestehenden Meßgröße wird vorteilhaft durch eine Demodulation und einer anschließenden Tiefpaßfilterung erreicht. Die Demodulation wird beispielsweise mit Hilfe eines 4-Quadranten-Multiplizierers durchgeführt.

Vorteilhaft ausgestaltet wird die Erfindung weiterhin dadurch, daß der Regler und/oder der Schaltungsblock in einer Digitalschaltung realisiert sind.

Es besteht grundsätzlich die Möglichkeit, sowohl den Regler als auch den Schaltungsblock, die die erste und zweite Stellgröße erzeugen, in einer Analog- oder in einer Digitalschaltung zu realisieren. Insbesondere die Realisierung des Schaltungsblockes, der zur Erzeugung der zweiten Stellgröße bzw. zur Bestimmung des Vorstromes vorgesehen ist, in einer Digitalschaltung ist vorteilhaft, da das vorgegebene Schema zur Bestimmung des Vorstromes leicht umsetzbar ist. Bei Verwendung einer Digitalschaltung für den oben erwähnten Schaltungsblock ist es vorteilhaft, auch den Regler bei noch ungenutzter Rechenkapazität mit Hilfe dieser Digitalschaltung zu realisieren. Auf diese Weise kann der analoge Schaltungsaufwand reduziert werden. Es ergibt sich eine kostengünstige Schaltungsrealisierung.

Ausführungsbeispiele der Erfindung werden nachstehend anhand der Zeichnungen näher erläutert. Es zeigen:

Fig. 1 eine Laserdiodenkennlinie mit zugehörigen zeitlichen Verläufen des Laserstroms und der Lichtleistung,

Fig. 2 ein Blockschaltbild einer verwendeten Regelschaltung,

Fig. 3 ein Blockschaltbild eines optischen Senders mit den erfindungsgemäßen Merkmalen.

Fig. 4 ein Blockschaltbild eines Übertragungssystems mit einem optischen Sender nach Fig. 3.

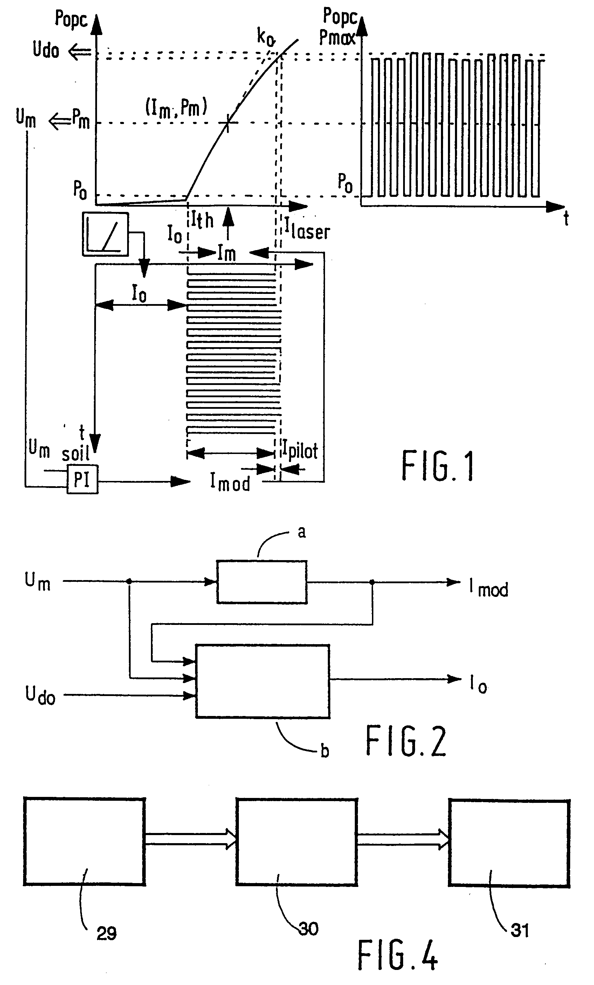

In Fig. 1 ist das Diagramm einer Laserdiodenkennlinie dargestellt. Auf der Abszisse ist der Laserstrom $I_{LASER}$, auf der Ordinate die Lichtleistung der Laserdiode $P_{opt}$ aufgetragen. Die Laserdiodenkennlinie läßt sich näherungsweise in zwei Abschnitte aufteilen. Die beiden Kennlinienabschnitte treffen sich in einem Knickpunkt der Laserdiodenkennlinie beim Schwellenstrom $I_{th}$. Das Kurvenstück, das im Bereich von Laserdiodenströmen $I_{Laser}$ liegt, die kleiner als der Schwellenstrom $I_{th}$ sind, besitzt nur eine sehr geringe Steilheit. Die Lichtleistung $P_{opt}$ ist dort vernachlässigbar klein. Der andere Teil der Kennlinie, aus dem sich die Lichtleistung $P_{opt}$ bei Laserdiodenströmen größer als der Schwellenstrom $I_{th}$ ergibt, besitzt eine erheblich größere Steilheit. Es ist ein Arbeitspunkt $(I_m, P_m)$ eingezeichnet. Der Bereich der Kennlinie zwischen dem Knickpunkt und diesem Arbeitspunkt ist gut durch ein Geradenstück anzunähern. Oberhalb des Arbeitspunktes flacht die Kennlinie merklich ab. Dieses überproportionale Abflachen tritt insbesondere bei einer Temperaturerhöhung der Laserdiode bzw. beim Alterungsvorgang auf. Bei zunehmender Temperatur bzw. größerem Alter verringert sich die Steilheit der gesamten Kennlinie oberhalb des Schwellenstroms $I_{th}$. Weiterhin ergibt sich ein erhöhter Schwellenstrom $I_{th}$.

Unterhalb des beschriebenen Diagramms ist ein beispielhafter zeitlicher Verlauf des Laserdiodenstroms $I_{Laser}$ dargestellt. Der Laserdiodenstrom $I_{Laser}$ setzt sich aus einem Vorstrom $I_0$, aus einem Modulationsstrom $I_{mod}$ und einem Pilotstrom $I_{Pilot}$ zusammen. Der Vorstrom $I_0$ ist ein reiner Gleichstrom. Er sorgt dafür, daß der Laserdiodenstrom $I_{Laser}$ zu jedem Zeitpunkt größer als der Schwellenstrom $I_{th}$ ist. Der Modulationsstrom $I_{mod}$ ist im vorliegendem Fall mit einem hochfrequenten binären Datensignal moduliert, dessen Frequenz im Bereich größer als 140 MHz liegt. Der dritte Anteil des Laserdiodenstroms $I_{Laser}$ ist der Pilotstrom $I_{Pilot}$. Dieser Pilotstrom ist mit einem digitalen Pilotsignal im Bereich einiger kHz moduliert. Wie der Modulationsstrom $I_{mod}$ stellt auch der Pilotstrom $I_{Pilot}$ ein binäres Signal dar. Die zwei möglichen binären Zustände "0" und "1" werden durch einen Modulationsstrom Null bzw. einen Maximalstrom dargestellt. Die Bitfolgefrequenz des Pilotstromes $I_{Pilot}$ beträgt im vorliegenden Beispiel 3,5 kHz. Die Amplitude des Pilotstromes $I_{Pilot}$ ist so groß wie der hundertste Teil der Amplitude des Modulationsstromes $I_{mod}$. Aus anschaulichen Gründen ist der Pilotstrom $I_{Pilot}$ nicht maßstabsgerecht im Vergleich zum Modulationsstrom $I_{mod}$ dargestellt.

Rechts vom Kennliniendiagramm der Laserdiode ist der dem beschriebenen Laserdiodenstrom $I_{Laser}$ entsprechende zeitliche Verlauf der Lichtleistung $P_{opt}$ dargestellt. Der zeitliche Verlauf der von der Laserdiodenkennlinie abhängigen Lichtleistung

$P_{opt}$ stellt eine Folge von Impulsen dar, denen zusätzlich ein Gleichanteil der Höhe $P_0$ - (Ruhelichtleistung) überlagert ist. Dieser Gleichanteil $P_0$ ist durch die Höhe des Vorstroms $I_0$ bestimmt. Die Höhe $P_{max}$ der Impulse wird durch die Amplituden des Modulationsstroms $I_{mod}$ und des Pilotstromes $I_{Pilot}$ bestimmt. So wird beispielsweise eine logische 1 durch einen Impuls der Höhe $P_{max}$ dargestellt, eine logische Null wird dementsprechend durch eine Impulspause mit der Lichtleistung $P_0$ beschrieben. Die Impulshöhe $P_{max}$ wird durch die Amplituden des Modulationsstrom $I_{mod}$ und des Pilotstromes $I_{Pilot}$ bestimmt.

Da sich die Form der Laserdiodenkennlinie in Folge von Temperaturerhöhungen oder Alterungsvorgängen wie oben beschrieben ändert, ist eine Regelung der Lichtleistung $P_{opt}$ notwendig. So soll der Gleichanteil $P_0$ und die Höhe $P_{max}$ der Impulse der Lichtleistung $P_{opt}$ konstant geregelt werden. Dies ist gleichbedeutend mit einer Regelung des Mittelwertes $P_m$ der Lichtleistung $P_{opt}$ und eines sogenannten Extinktionsfaktors, der das Verhältnis von $P_0$ zu $P_{max}$ darstellt, auf konstante Werte.

Zur Regelung des Mittelwertes $P_m$ ist ein PI-Regler PI vorgesehen, auf dessen Eingänge ein Sollwert $U_{m,soll}$ und eine Regelgröße $U_m$, die proportional zum Mittelwert $P_m$ ist, gegeben werden. Entsprechend der Differenz seiner Eingangsgrößen regelt der PI-Regler PI die Amplitude des Modulationsstromes $I_{mod}$ nach. Bei veränderter Laserdiodenkennlinie wird außerdem der Vorstrom $I_0$ nachgeregelt. Der Vorstrom $I_0$ wird dabei anhand eines vereinfachten Kennlinienmodells der Laserdiode errechnet, da während des Betriebs der Laserdiode kein genaues Ausmessen der Laserdiodenkennlinie möglich ist. Das vereinfachte Kennlinienmodell geht davon aus, daß bei Laserdiodenströmen $I_{Laser}$ die kleiner oder gleich dem Schwellenstrom $I_{th}$ sind, die Lichtleistung $P_{opt}$ gleich Null wird. Für Laserdiodenströme größer als der Schwellenstrom $I_{th}$ wird eine lineare Kennlinie angesetzt. Dieser Teil der Kennlinie ist bestimmt durch eine Steilheit $k_0$ und einen Arbeitspunkt $(I_m, P_m)$. Die Steilheit $k_0$ ist gleich der Steilheit bzw. gleich dem Differentialquotienten der nicht linearisierten Laserdiodenkennlinie im Bereich der Lichtleistung $P_{max}$. Der Mittelwert $P_m$ ist festgelegt. Dieser Wert wird durch den PI-Regler PI während des Betriebs der Laserdiode ständig nachgeregelt. Der Strom $I_m$ stellt den Mittelwert des Laserdiodenstroms $I_{Laser}$ dar. Dieser Wert wird errechnet oder bestimmt aus der Summe eines gespeicherten Vorstromwertes $I_0$ und der halben Höhe eines Stromimpulses des Modulationsstroms $I_{mod}$. Es wird hierbei vorausgesetzt, daß der Pilotstrom vernachlässigbar klein gegenüber dem Modulationsstrom ist und daß die für die Ermittlung von $I_m$ zur Verfügung stehende Zeitdauer groß gegen die Zeitdauer eines Impulses des Modulationsstromes $I_{mod}$ ist. Es wird außerdem davon ausgegangen, daß das Auftreten eines Impulses bzw. einer Impulspause des Modulationsstromes $I_{mod}$ gleichwahrscheinlich ist.

Fig. 2 zeigt das Prinzip einer Regelung des Modulationsstroms $I_{mod}$ und des Vorstroms $I_0$. Es ist ein Schaltungsblock a angeordnet, auf dessen Eingang die Regelgröße $U_m$ gegeben wird. Dieser Schaltungsblock a enthält einen Regler, der die Regelgröße $U_m$ mit einem Sollwert vergleicht und der die Amplitude von $I_{mod}$ bestimmt. Auf die Eingänge eines Schaltungsblockes b werden die Regelgröße $U_m$, eine Meßgröße $U_{d0}$ und das Ausgangssignal $I_{mod}$ des Schaltungsblockes a gegeben. Der Schaltungsblock b enthält eine Auswertevorrichtung, die aus den drei Eingangsgrößen den Vorstrom $I_0$ bestimmt.

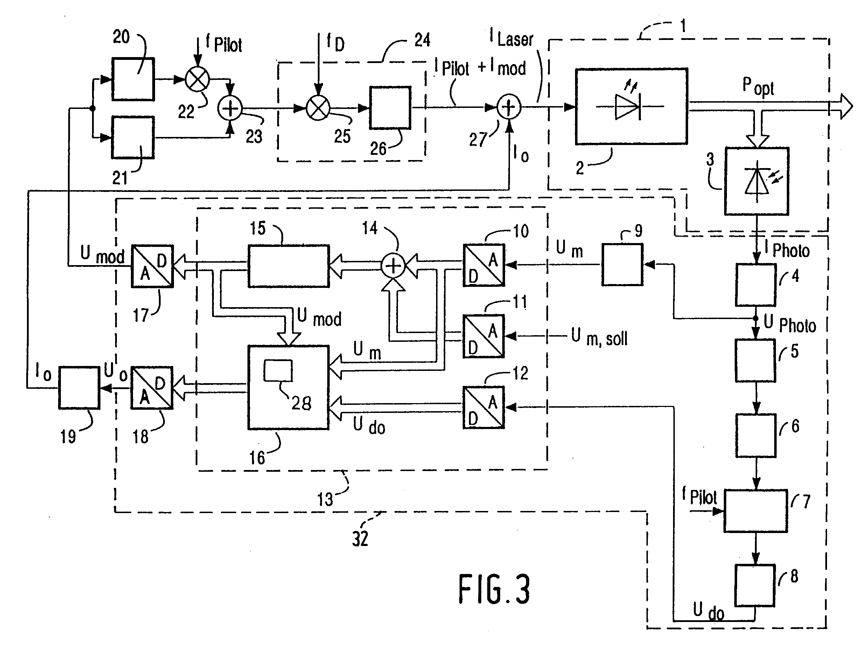

Fig. 3 zeigt das Blockschaltbild eines geregelten optischen Senders. Im Schaltungsblock 1 ist der optische Teil der Schaltungsanordnung zusammengefaßt. Er besteht aus einer Laserdiode 2, die Licht mit einer Lichtleistung $P_{opt}$ liefert und einer mit ihr gekoppelten Photodiode 3 als Monitordiode. Die Photodiode 3 liefert einen Photostrom $I_{Photo}$, der proportional zur Lichtleistung $P_{opt}$ ist. Der Photostrom $I_{Photo}$ wird durch einen Strom-Spannungs-Wandler 4 in eine Photospannung $U_{Photo}$ umgewandelt. Diese Photospannung $U_{Photo}$ wird einem Tiefpaß 9 zugeführt, an dessen Ausgang eine dem Mittelwert des Photostroms $I_{Photo}$ proportionaleSpannung $U_m$ anliegt. Die Spannung $U_{Photo}$ liegt weiterhin an einem Tiefpaß 5 an, dessen Ausgang mit dem Eingang eines Hochpasses 6 verbunden ist. Die Grenzfrequenz des Tiefpasses 5 liegt bei 100 kHz, die Grenzfrequenz des Hochpasses 6 liegt bei 1 kHz. Diese beiden Schaltungselemente besitzen somit die Wirkung eines Bandpasses. Das Ausgangssignal des Hochpasses 6 wird auf einem Demodulator (4-Quadranten-Multiplizierer) gegeben. Dieser demoduliert das Bandpaßsignal unter Verwendung der Pilotfrequenz $f_{Pilot}$. Ein Tiefpaß dämpft die hohen Spektralanteile des Demodulatorausgangssignals und liefert dessen Gleichanteil als Meßgröße $U_{d0}$. Die Regelgröße $U_m$, ein Sollwert $U_{m,soll}$ und die Meßgröße $U_{d0}$ werden auf drei Eingänge eines Mikrocontrollers 13 gegeben. An den drei Eingängen des Mikrocontrollers 13 sind drei Analog-Digital-Umsetzer 10, 11, 12 angeordnet, die die drei Eingangsgrößen digitalisieren. Im folgenden werden für digitale und entsprechende analoge Größen die gleichen Bezeichnungen benutzt. Im Mikrocontroller 13 ist ein Subtrahierer 14 vorgesehen, der die Differenz von $U_{m,soll}$ und $U_m$ bildet. Diese Differenz liegt am Eingang eines PI-Reglers 15 an. Die Verwendung anderer Regler-Typen, z. B. eines PID-Reglers, ist möglich. Der Regler 15 liefert eine erste Stellgröße $U_{mod}$. Der Ausgang des Reglers 15 ist weiterhin mit einem ersten Ausgang des Mikrocontrollers 13 gekoppelt. Im Mikrocontroller 13 ist weiterhin eine Auswerteeinheit 16, die einen Speicher 28 enthält, angeordnet. An drei Eingängen dieser Auswerteeinheit 16 liegen die in digitalisierter Form vorliegenden Größen $U_{mod}$, $U_m$ und $U_{d0}$ an. Diese werden von der Auswerteeinheit 16 gemäß einem noch zu erläuternden Rechenschema zu einer zweiten Stellgröße $U_0$, die an einem zweiten Ausgang des Mikrocontrollers 13 anliegt, weiterverarbeitet.

Die erste Stellgröße $U_{mod}$ wird mit Hilfe eines Digital-Analog-Umsetzers 17 in eine analoge erste Stellgröße (Gleichspannung) $U_{mod}$ umgewandelt. $U_{mod}$ liegt am Eingang eines Spannungs-Strom-Wandlers 20 an, dessen Ausgang mit dem Eingang eines Multiplizierers 22 gekoppelt ist. Der Multiplizierer 22 multipliziert sein Eingangssignal mit einem impulsförmigen binären Pilotsignal der Frequenz 3,5 kHz. Das Ausgangssignal des Multiplizierers 22 wird auf einen ersten Eingang des Addierers 23 gegeben. Parallel zum Spannungs-Strom-Wandler 20 und dem Multiplizierer 22 liegt ein Spannungs-Strom-Wandler 21. Dieser verwandelt die Gleichspannung $U_{mod}$ in einen Gleichstrom, der wesentlich größer (hier: Faktor 100) als der aus dem Ausgang des Spannungs-Strom-Wandlers 20 fließende Gleichstrom ist. Der so erzeugte Gleichstrom wird auf einen zweiten Eingang des Addierers 23 gegeben. Der so erzeugte aus dem Ausgang des Addierers 23 fließende Summenstrom wird einem Lasertreiber 24 zugeführt. Dieser besteht im wesentlichen aus einem weiteren Multiplizierer 25 und einem Verstärker 26. Der Multiplizierer 25 multipliziert den Summenstrom mit einem impulsförmigen, binären Datensignal der Frequenz $f_D$. Die Frequenz $f_D$ liegt im vorliegenden Beispiel im Bereich größer als 140 MHZ. Aus dem Ausgang des Lasertreibers 24 fließt die Summe aus dem Pilotstrom $I_{Pilot}$ und dem Modulationsstrom $I_{mod}$. Diese Summe wird einem Addierer 27 zugeführt. In einen weiteren Eingang des Addierers 27 fließt der Vorstrom $I_0$, der vom Ausgang eines Spannungs-Strom-Wandlers 19 geliefert wird. Dem Eingang dieses Spannungs-Strom-Wandlers 19 ist die zweite Stellgröße $U_0$, die von einem Digital-Analog-Umsetzer 18 von einem Digital- in ein Analog-Signal umgewandelt wurde, zugeführt. Die zweite Stellgröße $U_0$ ist proportional zum Vorstrom $I_0$. Aus dem Ausgang des Addierers 27 fließt der Laserstrom $I_{Laser}$, der die Laserdiode 2 aussteuert. Der Laserstrom $I_{Laser}$ setztsich aus der Summe von $I_{Pilot}$, $I_{mod}$ und $I_0$ zusammen.

Zu Beginn des Einsatzes des optischen Senders in einem optischen Nachrichtenübertragungssystem werden die Ruhelichtleistung $P_0$ und die Leistung $P_{max}$ der zu erzeugenden Lichtimpulse auf die gewünschten Werte eingestellt. $U_{mod}$ und $I_0$ werden auf geeignete Anfangswerte gesetzt. Festgelegt sind damit auch der gewünschte Mittelwert der Lichtleistung der Laserdiode, der bei näherungsweiser Gleichverteilung von Impulsen und Impulspausen gleich $(P_0 + P_{max})/2$ ist, und der entsprechende Extinktionsfaktor. Um beim alterungs- oder temperaturbedingten Abflachen der Laserdiodenkennlinie die vorgegebenen Werte der Lichtleistung $P_{opt}$ möglichst konstant zu halten, ist eine Regelschaltung 32 vorgesehen. Der Photostrom $I_{Photo}$ der Photodiode 3, die mit der Laserdiode 2 gekoppelt ist, wird zur Einstellung des Vorstroms $I_0$ und der Amplitude des Modulationsstroms $I_{mod}$ verwendet. Da die Photodiode 3 Tiefpaßwirkung besitzt und ihre Grenzfrequenz kleiner als die Frequenz $f_D$ des Datensignals ist, läßt sich aus dem Photostrom $I_{Photo}$ keine Aussage bezüglich $P_0$ und $P_{max}$ ableiten. Aus diesem Grund wird dem Laserdiodenausgangssignal ein Pilotsignal überlagert. Dieses wird von einem Pilotstrom $I_{Pilot}$ der Frequenz $f_{Pilot}$ erzeugt, die kleiner als die Tiefpaß-Grenzfrequenz der Photodiode ist. Die Pilotfrequenz $f_{Pilot}$ liegt also nicht im Sperrbereich der Photodiode 3. Aus dem Photostrom $I_{Photo}$ lassen sich eine erste und eine zweite Stellgröße $U_m$ beziehungsweise $U_{d0}$ wie oben beschrieben ableiten. $U_m$ ist proportional zum Mittelwert des Photostromes $I_{Photo}$ und damit auch proportional zum Mittelwert $P_m$ der Lichtleistung $P_{opt}$ der Laserdiode 2. $U_{d0}$ ist proportional zur Amplitude derjenigen Komponente des Photostroms $I_{Photo}$, deren Frequenz gleich der Grundfrequenz des Pilotstromes $I_{Pilot}$ ist, und damit auch proportional zur Steilheit beziehungsweise zum Differentialquotienten $k_0$ der Laserdiodenkennlinie im Bereich von $P_{max}$.

Mit Hilfe des Sollwertes $U_{m,soll}$ wird die gewünschte mittlere Lichtleistung $P_m$ der Laserdiode eingestellt. Der Regler 15 sorgt durch Nachführen der Stellgröße $U_{mod}$, die die Amplitude des Modulationsstromes $I_{mod}$ bestimmt, für die Konstanthaltung von $P_m$.

Im folgenden soll gezeigt werden, wie sich der Vorstrom $I_0$ aus den drei Eingangsgrößen der Auswerteeinheit 16 $U_{mod}$, $U_m$ und $U_{d0}$ beziehungsweise aus den zu diesen proportionalen Großen $I_{mod}$, $I_m$ und $k_0$ ergibt. Ein Schätzwert des Mittelwertes $I_m$ des Laserstroms $I_{Laser}$ berechnet sich aus

$$I_m = I_{0,alt} + \frac{I_{mod}}{2} \qquad (1)$$

$I_{0,alt}$ stellt einen im Speicher 28 gespeicherten Wert eines bereits vorher berechneten Vorstroms $I_0$ dar. $I_{mod}$ leitet sich direkt unter Berücksichtigung eines Proportionalitätsfaktors aus der Stellgröße $U_{mod}$ ab. Die Steilheit beziehungsweise den Differentialquotienten $k_0$ erhält man aus

$$k_0 = k \ \frac{U_{d0}}{U_{mod}} \qquad (2)$$

$U_{d0}$ ist proportional zur Steilheit bzw. zum Differentialquotienten $k_0$ der Laserdiodenkennlinie bei der maximalen Lichtleistung $P_{max}$. Im Faktor k sind die Verstärkungs- beziehungsweise Dämpfungsfaktoren der Regelschaltung 32 berücksichtigt. Die Stellgröße $U_{mod}$ muß in die Bestimmung von $k_0$ eingehen, weil die Amplitude des Pilotstromes $I_{Pilot}$ nicht konstant ist, sondern aus $U_{mod}$ abgeleitet wird. Der Schwellenstrom $I_{th}$ ergibt sich unter Anwendung des linearisierten Kennlinienmodells der Laserdiode zu

$$I_{th} = I_m - \frac{P_m}{k_0} \qquad (3)$$

Die mittlere Lichtleistung $P_m$ ist dabei durch die Eingangsgröße $U_m$ des Mikrocontrollers 13 bestimmt. Der Vorstrom $I_0$ errechnet sich schließlich zu

$$I_0 = I_{th} + \frac{P_0}{k_0} \qquad (4)$$

Die Ruhelichtleistung $P_0$ ist eine vorgegebene konstante Große. $I_{th}$ und $k_0$ ergeben sich aus den Formeln (1) bis (3).

Bei temperatur- oder alterungsbedingtem Abflachen der Laserdiodenkennlinie regelt zunächst der schnell reagierende Regler 15 die erste Stellgröße $U_{mod}$ bzw. den Modulations-Strom $I_{mod}$ hoch, um die mittlere vorgegebene Lichtleistung $P_m$ konstant zu halten. Die Auswerteeinheit 16 erhöht nun gemäß den Gleichungen (1) bis (4) den Vorstrom $I_0$. So wird durch ein Erhöhen des Modulationsstromes $I_{mod}$ gemäß gleichung (1) eine Erhöhung des Mittelwerts $I_m$ des Laserdiodenstromes bewirkt. Dies führt nach Gleichung (3) zu einem höheren Wert bei der Berechnung des Schwellenstromes $I_{th}$. Die Vergrößerung des Summanden $P_m/k_0$ durch das verkleinerte $k_0$ wird überkompensiert. Gleichung (4) führt mit diesem Ergebnis auf eine Vergrößerung von $I_0$. Obwohl ein Abflachen der Laserdiodenkennlinie mit einem Anstieg des Schwellenstroms $I_{th}$ verbunden ist, kann so verhindert werden, daß der Vorstrom $I_0$ kleiner als der Schwellenstrom $I_{th}$ wird. Verzerrungen des Laserdiodenausgangssignals werden vermieden. Die Regelschaltung 32 garantiert auf diese Weise außerdem, daß der Mittelwert $P_m$ und der Extinktionsfaktor der

Lichtleistung $P_{opt}$ nahezu konstant bleiben.

In Fig. 4 ist ein optisches Übertragungssystem dargestellt. Es ist ein optischer Sender 29 angeordnet, dessen Aufbau und Funktionsweise in den Figuren 1 bis 3 beschrieben ist. Weiterhin ist eine Lichtwellenleiter-Übertragungsstrecke 30 vorgesehen, die zur Übertragung der vom Sender 29 erzeugten optischen Signale dient. Am anderen Ende der Übertragungsstrecke 30 ist ein optischer Empfänger 31 zum Empfang der Signale vorgesehen.

**Patentansprüche**

1. Optisches Übertragungssystem mit einer Laserdiode (2) und einer mit ihr gekoppelten Photodiode (3), deren Photostrom ($I_{Photo}$) einer Regelschaltung (32) zur Regelung der Lichtleistung ($P_{opt}$) zugeführt wird, die eine erste und zweite Stellgroße ($U_{mod}$, $U_0$) für einen Modulationsstrom ($I_{mod}$) und einen Vorstrom ($I_0$) vorgibt und mit einer Anordnung zur Bestimmung eines aus der Lichtleistung ($P_{opt}$) und aus dem durch die Laserdiode fließenden Laserstrom ($I_{Laser}$) gebildeten Differentialquotienten ($k_0$), **dadurch gekennzeichnet,** daß die Regelschaltung (32) vorgesehen ist
   - zur Erzeugung der ersten Stellgröße ($U_{mod}$) mittels einer aus dem Mittelwert des Photostromes ($I_{Photo}$) abgeleiteten Regelgröße ($U_m$) und
   - zur Erzeugung der zweiten Stellgröße ($U_0$) aus dem gemessenen Differentialquotienten ($k_0$), aus dem Mittelwert ($P_m$) der optischen Leistung ($P_{opt}$) und aus dem Mittelwert ($I_m$) des Laserdiodenstroms ($I_{Laser}$).

2. Optisches Übertragungssystem nach Anspruch 1, **dadurch gekennzeichnet,** daß die Regelschaltung (32) vorgesehen ist zur Schätzung des Mittelwerts ($I_m$) des Laserdiodenstroms ($I_{Laser}$) durch die Summe aus dem Mittelwert ($I_{mod}/2$) des Modulationsstromes ($I_{mod}$) und eines vorher bestimmten und gespeicherten Vorstromwertes ($I_{0,alt}$).

3. Optisches Übertragungssystem nach einem der Ansprüche 1 bis 2, **dadurch gekennzeichnet,** daß die Regelschaltung (32) vorgesehen ist zur Verwendung der am Ausgang eines Reglers (15) anliegenden ersten Stellgröße ($U_{mod}$) zur Bestimmung des Vorstroms ($I_0$).

4. Optisches Übertragungssystem nach einem der Ansprüche 1 bis 3, **dadurch gekennzeichnet,**

daß Modulationsmittel (22) vorgesehen sind zur Modulation des Laserstroms ($I_{Laser}$) mit einem Pilotstrom ($I_{Pilot}$) und daß die Regelschaltung (32) zur Bestimmung des Differentialquotienten ($k_0$) durch Ermittlung einer Meßgröße ($U_{d0}$) vorgesehen ist, die der Amplitude derjenigen Komponente des Photostroms ($I_{Photo}$) entspricht, deren Frequenz gleich der Grundfrequenz des Pilotstromes ($I_{Pilot}$) ist.

5.  Optisches Übertragungssystem nach Anspruch 4,
    <u>dadurch gekennzeichnet,</u>
    daß zur Einstellung der Amplitude des Pilotstroms ($I_{Pilot}$) die erste Stellgröße ($U_{mod}$) vorgesehen ist.

6.  Optisches Übertragungssystem nach einem der Ansprüche 1 bis 5,
    <u>dadurch gekennzeichnet,</u>
    daß ein Schaltungsblock (16) vorgesehen ist, der zur Erzeugung der zweiten Stellgröße ($U_0$) dient,
    daß an den Eingängen dieses Schaltungsblockes (16) die Regelgröße ($U_m$), die Meßgröße ($U_{d0}$) und die erste Stellgröße ($U_{mod}$) anliegt und
    daß der Schaltungsblock (16) einen Speicher zur Speicherung mindestens eines Wertes des Vorstromes ($I_0$) enthält.

7.  Optisches Übertragungssystem nach einem der Ansprüche 1 bis 6,
    <u>dadurch gekennzeichnet,</u>
    daß zur Bestimmung der Meßgröße ($U_{d0}$) aus dem Photostrom ($I_{Photo}$) eine Bandpaßfilterung (5, 6), eine Demodulation (7) und eine anschließende Tiefpaßfilterung (8) vorgesehen sind.

8.  Optisches Übertragungssystem nach einem der Ansprüche 1 bis 7,
    <u>dadurch gekennzeichnet,</u>
    daß der Regler (15) und/oder der Schaltungsblock (16) in einer Digitalschaltung realisiert sind.

9.  Optischer Sender mit einer Laserdiode (2) und einer mit ihr gekoppelten Photodiode (3), deren Photostrom ($I_{Photo}$) einer Regelschaltung (32) zur Regelung der Lichtleistung ($P_{opt}$) zugeführt wird, die eine erste und zweite Stellgröße ($U_{mod}$, $U_0$) für einen Modulationsstrom ($I_{mod}$) und einen Vorstrom ($I_0$) vorgibt und mit einer Anordnung zur Bestimmung eines aus der Lichtleistung ($P_{opt}$) und aus dem durch die Laserdiode fließenden Laserstrom ($I_{Laser}$) gebildeten Differentialquotienten ($k_0$),

<u>dadurch gekennzeichnet,</u>
daß die Regelschaltung (32) vorgesehen ist

-   Zur Erzeugung der ersten Stellgröße ($U_{mod}$) mittels einer aus dem Mittelwert des Photostromes ($I_{Photo}$) abgeleiteten Regelgröße ($U_m$) und
-   zur Erzeugung der zweiten Stellgröße ($U_0$) aus dem gemessenen Differentialquotienten ($k_0$), aus dem Mittelwert ($P_m$) der optischen Leistung ($P_{opt}$) und aus dem Mittelwert ($I_m$) des Laserdiodenstroms ($I_{Laser}$).

FIG.1

FIG.2

FIG.4

FIG.3

EP 0 625 835 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| A | EP-A-0 141 192 (SIEMENS)<br>* Seite 1, Zeile 34 – Zeile 36 *<br>* Seite 4, Zeile 10 – Zeile 12 *<br>* Seite 7, Zeile 9 – Seite 8, Zeile 10 *<br>* Abbildung 3 *<br>----- | 1-9 | H04B10/14 |
| | | | RECHERCHIERTE SACHGEBIETE (Int.Cl.5) |
| | | | H04B |

Der vorliegende Recherchenbericht wurde für alle Patentansprüche erstellt

| Recherchenort | Abschlußdatum der Recherche | Prüfer |
|---|---|---|
| DEN HAAG | 4. August 1994 | Williams, M.I. |